(19) Europäisches Patentamt
European Patent Office
Office européen des brevets

(11) **EP 2 287 932 B1**

(12) **EUROPEAN PATENT SPECIFICATION**

(45) Date of publication and mention
of the grant of the patent:
**20.02.2019 Bulletin 2019/08**

(51) Int Cl.:
***H01L 33/58*** (2010.01)  ***F21V 5/04*** (2006.01)
***G03B 15/02*** (2006.01)

(21) Application number: **10008709.7**

(22) Date of filing: **20.08.2010**

(54) **LED lighting apparatus**

LED-Beleuchtungsvorrichtung

Appareil d'éclairage à DEL

(84) Designated Contracting States:
**AL AT BE BG CH CY CZ DE DK EE ES FI FR GB
GR HR HU IE IS IT LI LT LU LV MC MK MT NL NO
PL PT RO SE SI SK SM TR**

(30) Priority: **21.08.2009 JP 2009192499**

(43) Date of publication of application:
**23.02.2011 Bulletin 2011/08**

(73) Proprietor: **Stanley Electric Co., Ltd.
Meguro-ku
Tokyo 153-8636 (JP)**

(72) Inventors:
• **Hiramoto, Aki**
  **Tokyo 153-8636 (JP)**
• **Kano, Hiroyuki**
  **Tokyo 153-8636 (JP)**

(74) Representative: **Wagner, Karl H.
Wagner & Geyer
Gewürzmühlstrasse 5
80538 Munich (DE)**

(56) References cited:
**JP-A- 2006 024 615     US-A1- 2004 201 987**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

**Background of the Invention**

**1. Field of the Invention**

The present invention relates to a lighting apparatus which uses a light emitting device (LED: light emitting diode) as a light source, and includes a phosphor layer to perform color conversion. More particularly, the present invention relates to a lighting apparatus suitable for strobe use.

**2. Description of the Related Art**

There is a type of mobile phone being equipped with a light emission unit that serves as a small-sized stroboscopic unit for a camera function, using an LED as a light source (see JP 2009-16779 A). The light emission unit described in JP 2009-16779 A is provided with the LED for emitting blue light, and a phosphor layer which is excited by the blue light and emits yellow fluorescence, and the light emission unit irradiates a subject with white light that is obtained by mixing the blue light and the yellow fluorescence. This phosphor layer is excited also by outside light and emits yellow light. Therefore, this light emission unit looks yellow due to ambient light in the state where the light emission unit is not lighted, and this spoils the appearance. JP 2009-16779 A suggests that a resin layer in which light diffusion materials are dispersed is placed on the phosphor layer.

According to the technique as described in JP 2009-16779 A, when the resin layer in which the light diffusion materials are dispersed is placed on the phosphor layer, the outside light is reflected irregularly by the light diffusion materials, rendering the color whitish, and therefore reducing visibility of the yellow color on the phosphor layer. However, since the layer containing the light diffusion materials has the operations for diffusing the emission from the LED and the fluorescence from the phosphor layer, and reducing transmittance, there is a problem that this makes it hard to obtain light distribution and brightness which are necessary for the strobe light.

US 2004/0201987 A1 discloses an LED lamp including a circuit substrate on which an electrode pattern is formed, a reflecting frame including a tapered concave portion having an inner peripheral surface broadening toward an upper end of the reflecting frame, a light emitting unit disposed on a central portion of the concave portion, an air layer disposed above the light emitting unit, and a lens body provided through the air layer above the reflecting frame, the reflecting frame being provided with an air hole for communicating the air layer with an outside area of the LED lamp. A rough surface may be provided on a surface of the lens body facing the light emitting unit.

JP 2006-024615 A discloses an LED lighting source which includes an LED chip mounted on a substrate, a fluorescent material resin covering the LED chip, and a transparent resin covering the fluorescent material resin. The fluorescent material resin is formed of a fluorescent material for converting the light emitted from the LED chip to the light having the wavelength which is longer than that of the relevant light and a resin for dispersing the fluorescent material. The upper surface of the transparent resin is the LED lighting source which is formed to have unevenness.

An aspect of the present invention is to provide a lighting apparatus in which the color of the phosphor layer is almost invisible from the environment, and the apparatus enables to obtain light from the LED, achieving necessary light distribution and brightness.

**Summary of the Invention**

The present invention provides the lighting apparatus as described in claim 1. Since the prism made up of the convex stripes being aligned reflects the outside light, it is possible to suppress the situation that the color of the phosphor is visible from the outside, when light beams are not emitted. In addition, since the prism controls the light distribution of the emission from the LED, this can be utilized to control the light distribution for a function as a stroboscopic unit.

It is desirable that the region on the transparent body, where the prism is formed, overlays all over the phosphor-containing layer.

A reflector having a predetermined aperture, for instance, is placed around the LED. Preferably, the transparent body is placed in such a manner as covering the aperture of the reflector.

If the aperture of the reflector takes the shape having a longitudinal direction and a short-side direction, it is preferable that the longitudinal direction of the convex stripes of the prism is parallel to the short-side direction of the aperture.

It is desirable that on the transparent body inside the aperture of the reflector, a second region where the prism is not formed exists around the region where the prism is formed.

It is possible to configure such that a front edge of the reflector is positioned more distant from the LED than the prism of the transparent body.

In this case, the transparent body may be configured in such a manner that an inclined plane is provided in a region between the front edge of the reflector and the prism.

Preferably, each of the multiple convex stripes has a triangular cross section, and the size of a vertical angle on the tip varies in multiple types.

It is further possible to configure such that each of the multiple convex stripes has a triangular cross section, and at least some of the convex stripes have the vertical angle on the tip being asymmetrical with respect to the normal line of the substrate.

It is possible to provide a refractive type Fresnel lens on the upper surface of the transparent body.

It is further possible that on the surface of the transparent body, being opposed to the LED, a reflective type Fresnel lens is provided around the region where the prism is formed.

According to the lighting apparatus of the present invention, the prism in which the convex stripes are aligned reflects the outside light, and it is possible to suppress the situation that the color of the phosphor is visible from the outside when the light is not emitted. In addition, the prism operates effectively to render the LED emission to have a light distribution (homogeneous irradiation on the plane, and horizontally long light distribution to be suitable for an imaging range), which is required for the use as a stroboscopic unit. Therefore, it is possible to provide a lighting apparatus for strobe use, in which the color of the phosphor layer is almost invisible from the surrounding environment, and the light emission from the LED is controlled for appropriate light distribution.

## Brief Description of the Drawings

FIG. 1(a) is a top view of the LED lighting apparatus according to the embodiment 1, and FIG. 1(b) illustrates a shape of an imaging area subjected to stroboscopic irradiation by the LED lighting apparatus according to the embodiment 1;

FIG. 2 is a sectional view of the LED lighting apparatus according to the embodiment 1;

FIG. 3(a) is a cross sectional view showing the shape of the prism in the LED lighting apparatus according to the embodiment 1, and FIG. 3(b) and FIG. 3(c) are cross sectional views each showing the shape of the prism in the LED lighting apparatus according to the embodiment 2, the prism being provided with a curved surface or a flat surface;

FIG. 4 illustrates a prism vertical angle $\theta$ and a view angle $\varphi$, and reflection of the light beams according to the embodiment 1;

FIG. 5(a), FIG. 5(b), and FIG. 5(c) are globular projection views showing the light distribution characteristics of the prism 6, respectively for the cases where the vertical angle $\theta$ of the prism 6 in the LED lighting apparatus of the embodiment 1 is 100°, 90°, and 80°;

FIG. 6(a) is a globular projection view and FIG. 6(b) is a distribution chart of surface irradiation light amount, representing the light distribution characteristics which are obtained by the LED lighting apparatus according to the embodiment 1;

FIG. 7 is a cross sectional view of the LED lighting apparatus according to the embodiment 2;

FIG. 8 is a cross sectional view of the LED lighting apparatus which is provided with a refractive type Fresnel lens according to the embodiment 3;

FIG. 9 is a cross sectional view of the LED lighting apparatus which is provided with a reflective type Fresnel lens according to the embodiment 3; and

FIG. 10 is a cross sectional view of the lighting apparatus according to the embodiment 4.

## Description of the Preferred Embodiments

An LED lighting apparatus according to one embodiment of the present invention will be explained, with reference to the accompanying drawings.

Since the lighting apparatus according to the present embodiment uses an LED, it is suitable as a small-sized stroboscopic light emitting apparatus. In particular, it is suitable to be used as a stroboscopic unit for a mobile phone or a compact camera, since the color of the phosphor resin layer is almost invisible from the outside, achieving preferable appearances, as well as showing excellent light distribution characteristics.

## (Embodiment 1)

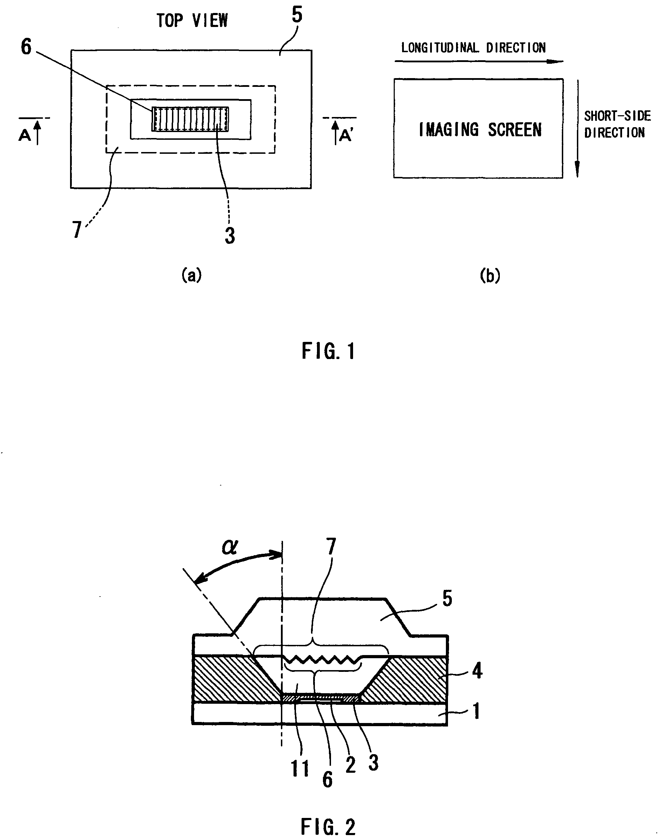

With reference to the top view as shown in FIG. 1(a) and the A-A' sectional view shown in FIG. 2, an explanation will be made as to a configuration of the lighting apparatus according to the embodiment 1. The lighting apparatus is provided with a substrate 1, an LED 2 installed on the substrate 1, a phosphor resin layer 3 covering the LED 2, a reflector 4 mounted on the substrate 1, and a lens 5.

For example, the LED 2 that outputs blue light or purple light may be employed. The phosphor resin layer 3 may be made of transparent resin in which phosphors are dispersed. The blue light or the purple light is used as excitation light, and the phosphors emitting fluorescence of blue, green, orange, or red are employed as a single substance or a mixture thereof. The color of appearance of these phosphors is yellow or orange when the light is not emitted. In the present embodiment, the color of the phosphors is almost invisible from the outside when the light is not emitted, according to the operation of a prism 6 which will be described below.

The reflector 4 has an aperture 7 being rectangular in shape, and the inner wall surface is inclined at a predetermined aperture angle $\alpha$. The LED 2 is placed at the center of the aperture 7 of the reflector 4. The phosphor resin layer 3 is placed in such a manner as filling up the opening of the reflector 4 on the side coming into contact with the substrate 1.

The lens 5 is mounted in such a manner that it covers the upper side aperture 7 of the reflector 4. There is formed the prism 6 in a predetermined region on the surface of the lens 5, on the side opposed to the phosphor resin layer 3. The range of the region in which the prism 6 is formed is approximately equal to the shape and the size of the phosphor resin layer 3, and covers the phosphor resin layer 3. A second region around the prism-formed region i.e., the region where the prism 6 is not formed is parallel to the principal plane of the substrate 1. The top surface (the outside surface) of the lens 5 has a convex shape corresponding to the shape of an aperture or the like of a mounting enclosure, such as a mobile phone and a compact camera. At least a region of the top surface of the lens 5, the region being opposed to the phosphor resin layer 3, is parallel to the principal plane of the substrate 1. There is air space 11 between the lens 5 and the phosphor resin layer 3.

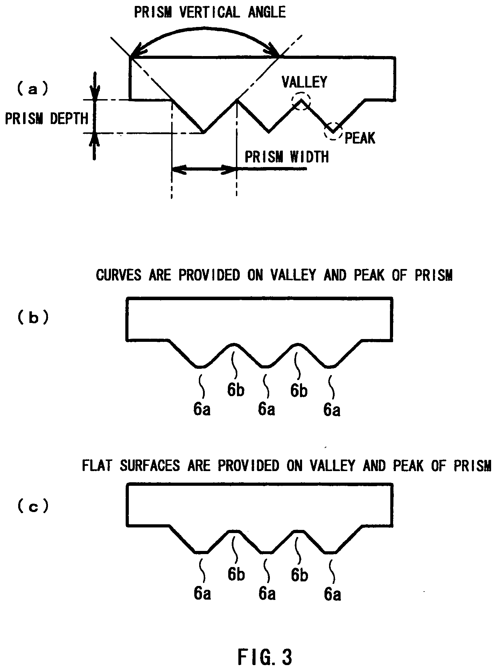

The prism 6 takes a structure in which multiple convex stripes each having a triangular cross section (FIG. 3(a)) are arranged in parallel as shown in FIG. 1(a), and the longitudinal direction of the convex stripes agrees with the short-side direction of the rectangular aperture of the reflector 4. In other words, as shown in FIG. 1(b), the shape of the rectangular aperture 7 of the reflector 4 has the longitudinal direction which corresponds to the longitudinal direction of the imaging screen (imaging area) of the camera. Therefore, the longitudinal direction of the convex stripes of the prism 6 is made to agree with the short-side direction of the imaging screen.

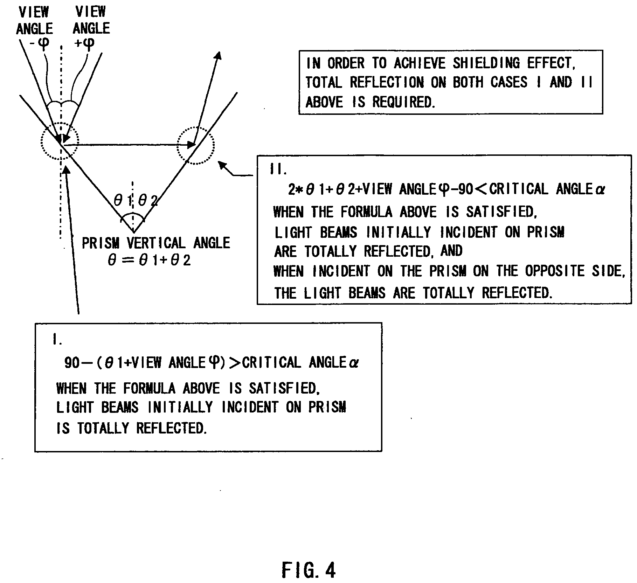

The vertical angle $\theta$ of the prism 6 is defined so as to achieve the followings as shown in FIG. 4; in the direction orthogonal to the longitudinal direction of the convex stripes (the longitudinal direction of the aperture 7), the light which is incident upon the prism 6 going through the lens 5 from the outside in the direction of the front view (the normal direction of the principal plane of the substrate 1) or in a predetermined field angle range (from $-\varphi$ to $+\varphi$) of the front view, is allowed to be totally reflected by two inclined planes of the prism 6 and outputted toward the outside again. In other words, the light incident upon the lens 5 from the outside and also incident upon the prism 6 at a predetermined view angle is retroreflected (reflected to the upside of the lens 5). It is to be noted that in the present application, the retroreflection includes not only the light completely reflected in the incident light direction, but also the light reflected in the direction deviated from the incident light direction, as far as it is reflected to the upside of the lens 5. With this configuration, the light incident upon the lens 5 from the outside is totally reflected, and it does not reach the phosphor resin layer 3. Therefore, it is possible to obtain an effect that the color of the phosphor itself (reflected light of the outside light generated by the phosphor) is made invisible from the outside (i.e., shielding effect). The prism 6 acts on the light substance that is incident in the direction which is orthogonal to the longitudinal direction of the convex stripes of the prism 6. The prism 6 does not produce the prism effect as to the light substance that is incident in the direction parallel to the longitudinal direction of the convex stripes. Therefore, there is no shielding effect for the light substance in this direction.

The vertical angle $\theta$ of the prism 6 is designed in accordance with the refraction index n of the material constituting the lens 5 and the view angle range (from $-\varphi$ to $+\varphi$) for the effect of shielding. It is desirable that the prism 6 has the shielding effect at least in the front view ($\varphi = 0$).

It is to be noted that the vertical angle $\theta$ may not necessarily have a shape symmetrical with respect to the normal direction of the substrate, and an asymmetrical shape is also applicable. In other words, as shown in FIG. 4, when it is assumed that the angle $\theta$ includes the angles $\theta 1$ and $\theta 2$, placing the normal line therebetween ($\theta = \theta 1 + \theta 2$), the angle $\theta 1$ is not necessarily equal to the angle $\theta 2$.

The vertical angle $\theta$ of the prism 6, which achieves the retroreflection at the predetermined view angle (from $-\varphi$ to $+\varphi$), can be determined by the formulas as described in the following (1) to (4):

$$90 - (\theta 1 + \varphi) > \sin^{-1}(1/n) \qquad \ldots \quad (1)$$

$$90 - (\theta 2 + \varphi) > \sin^{-1}(1/n) \qquad \ldots \quad (2)$$

$$2 \times \theta 1 + \theta 2 + \varphi - 90 > \sin^{-1}(1/n) \ldots \quad (3)$$

$$\theta 1 + 2 \times \theta 2 + \varphi - 90 > \sin^{-1}(1/n) \ldots \quad (4)$$

In particular, the vertical angle $\theta$ which is bilaterally symmetrical ($\theta 1 = \theta 2$) and produces the shielding effect in the front view ($\varphi = 0$), is obtained by the following formulas (5) and (6):

$$90 - \theta/2 > \sin^{-1}(1/n) \qquad \ldots \quad (5)$$

$$3 \times \theta/2 - 90 > \sin^{-1}(1/n) \qquad \ldots \quad (6)$$

The above formulas (1) to (6) are calculated geometrically according to the ray tracing illustration as shown in FIG. 4. For example, the formula (5) is a conditional expression according to which the light beams incident on the prism 6 are totally reflected by one reflection plane of the prism 6, in the case where the vertical angle $\theta$ is symmetrical ($\theta 1 = \theta 2$) and viewing is performed from the front side ($\varphi = 0$). The formula (6) is a conditional expression according to which the light beams totally reflected by one reflection plane are also totally reflected by the other reflection plane. When both the formulas (5) and (6) are satisfied, the incident light is reflected in the direction in which the light is incident on the lens 5. Accordingly, it is possible to obtain the shielding effect that the outside light is not allowed to reach the phosphor resin layer 3.

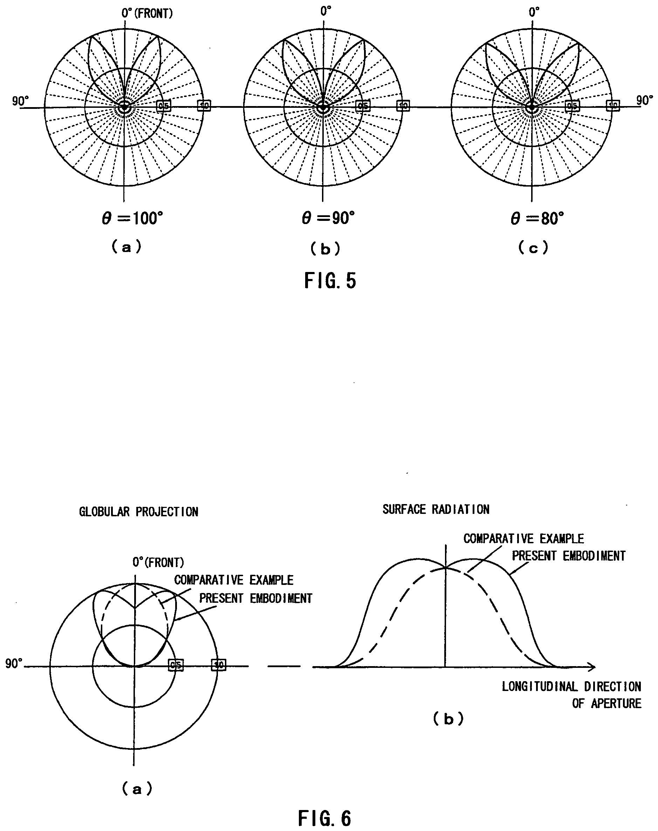

On the other hand, the light outputted from the LED 2 passes through the prism 6, whereby the light distribution is bipolarized with respect to the longitudinal direction of the aperture 7, i.e., the longitudinal direction of the imaging screen. FIG. 5(a), FIG. 5(b), and FIG. 5(c) are globular projection views showing the light distribution characteristics of the light that is outputted from the LED 2 and passes through the prism 6, respectively for the cases where the vertical angle $\theta$ is 100°, 90°, and 80° ($\theta = \theta 1 + \theta 2$, $\theta 1 = \theta 2$). As is apparent from FIG. 5(a), FIG. 5(b), and FIG. 5(c), it is found that the larger is the vertical angle $\theta$, the smaller is a dispersion angle (an aperture angle of the distribution light that is bipolarized). Therefore, the vertical angle $\theta$ of the prism 6 is configured according to a value of the ratio of the imaging screen, the longitudinal direction to the short-side direction, thereby enabling the control of the dispersion angle, and the overall imaging screen is irradiated with the light. Specifically, the vertical angle $\theta$ of the prism 6 is set to a small value to achieve a large dispersion angle, and this enables the overall imaging screen to be illuminated, when the imaging screen has the ratio larger in the longitudinal direction relative to the short-side direction.

As described above, it is desirable to configure the vertical angle $\theta$ of the prism 6 in such a manner that the angle achieves retroreflection of the outside light which is incident on the lens 5 at the predetermined view angle (from $-\varphi$ to $+\varphi$) from the outside, and also the angle enables the light outputted from the LED 2 to be dispersed on the overall predetermined imaging screen.

The reflector 4 operates to turn up the light emitted from the LED 2 in the front direction and outputs the light outwardly from the region of the lens 5, surrounding the region where the prism 6 is formed. With this configuration, the light distribution characteristics bipolarized by the prism 6 are combined with the light distribution characteristics of the light turned up in the front direction by the reflector 4, thereby obtaining the light distribution characteristics as illustrated by the globular projection view shown in FIG. 6(a). In other words, as shown in FIG. 5(a) to FIG. 5(c), the intensity of the light distributed in the front direction is approximately zero, the light being outputted from the LED 2 and passing through the prism 6. However, by adding the light being turned up in the front direction by the reflector 4, the light intensity distributed in the front direction is increased as shown in FIG. 6 (a), and the reflector 4 provides the light distribution in the front direction, compensating for the light distribution characteristics being bipolarized by the prism 6. It is to be noted that the aperture angle of the reflector 4 is configured according to the angle to turn up the light, which is necessary for achieving a desired light distribution. By way of example, the aperture angle $\alpha$ may be set to a value from 20° to 40°.

Therefore, the light amount distribution on the plane that is irradiated with the light from the lighting apparatus having the light distribution characteristics as shown in FIG. 6(a) becomes homogeneous across a large region in the longitudinal direction of the aperture 7 (in the longitudinal direction of the imaging screen) as shown in FIG. 6(b). By way of comparison, FIG. 6(a) illustrates the light distribution characteristics of the globular projection of the LED 2, in the case where the light distribution is controlled by using a Fresnel lens or the like, instead of the prism 6. It is found that the light distribution in the front direction is the largest. As shown in FIG. 6(b), in the light amount distribution on the plane irradiated with the light from the LED 2 in the comparative example, the region where the light amount distribution is homogeneous is narrower than the lighting apparatus which is provided with the prism 6 and the reflector 4 of the present embodiment. Accordingly, it is possible to obtain the homogeneous light amount distribution in a large region of the imaging area in the lighting apparatus of the present embodiment. Therefore, it is obvious that the imaging area is irradiated with homogeneous light, even in the case where the imaging area offers the ratio of the longitudinal direction being large relative to the short-side direction.

In addition, in the present embodiment, the prism 6 includes convex stripes, and takes the shape of prism only in the direction orthogonal to the longitudinal direction of the convex stripes (in the long side direction of the aperture 7 of the reflector 4), whereas there is no prism shape in the longitudinal direction of the convex stripes. Therefore, as for the light from the LED 2, the light distribution is bipolarized in the long side direction of the aperture 7, but it is not bipolarized in the short side direction. Accordingly, in comparison to the prism taking prism shapes in two ways (e.g., pyramid shape), there is a merit that the prism 6 brings high efficiencies in extracting light in the on-axis direction (front direction) of the light from the LED 2.

At the same time, the effect to shield the phosphor resin layer 3 from the light reaching from the outside cannot be obtained in the longitudinal direction of the convex stripes of the prism 6, and such shielding effect is produced only in the direction orthogonal to the longitudinal direction. With this shielding effect in the direction orthogonal to the longitudinal direction of the convex stripes, the light amount from the outside reaching the phosphor is drastically reduced. Therefore, it is possible to largely mitigate the phenomenon that the appearance color of the phosphor in the phosphor resin layer 3 is visible from the outside.

If the compatibility is considered between the efficiency to extract the light emitted from the LED 2 to the outside, and the effect to suppress the phenomenon that the color of the phosphor is visible from the outside when the LED 2 does not emit the light, it is preferable to render the prism 6 to be a type having convex stripes in the shape of prism, only in one direction.

If a width of each convex stripe of the prism 6 (a prism width, see FIG. 3(a)) is equal to or less than 100 $\mu$m, the visibility of the convex stripes is below the threshold of a resolution of human eyes. Therefore, the convex stripes are invisible to the naked eyes, and preferably, this improves the appearance.

Specifically, as a material of the lens 5, it is possible to employ a generally-used transparent resin, silicone, epoxy, acrylic (n = 1.48), polycarbonate (n = 1.58), or the like. On this occasion, when $\theta1 = \theta2 = 45°$, any of the lens materials described above may retroreflect the outside light at the front view $\varphi = 0°$, and therefore, this produces the shielding effect. It is checked whether the shielding effect is produced or not, by varying the values of $\theta$ and $\varphi$ when $\theta1 = \theta2$, as to each of the lens materials described above, and it is found that the case where $\theta1 = \theta2 = 45°$ achieves the widest range of the view angle, which can produces the shielding effect. If only the shielding from the outside light and suppressing the visibility of the phosphor color are considered, it is advantageous in terms of shielding, that prisms (convex stripes) having such angles are provided serially on the lens. However, as described above, if it is considered not only the effect for shielding from the outside light, but also the dispersion of the light emitted from the LED 2, the following settings are configured.

In other words, for example, when polycarbonate with the refraction index n = 1.58 is employed as the material of the lens 5, it is desirable to set the vertical angle $\theta = \theta1 + \theta2$ of the convex stripe in the prism 6 to be:

$$\pm 43.1° < \theta1, \theta2 < \pm 50.8°$$

Only one identical value may be taken as the vertical angle $\theta$ of the prism 6. However, if the prism is made up of multiple types of convex stripes, multiple types of dispersion angles (aperture angles of the bipolarized light distribution) as shown in FIG. 5(a) to FIG. 5(c) are produced, and this is preferable since such various angles may enhance the homogeneity of the light distribution outputted from the LED 2 and bipolarized by the prism 6. In this case simultaneously, multiple types of view angles of the light incident on the lens 5 from the outside and retroreflected by the prism 6 are produced, and therefore, it is possible to obtain an effect that the view field is expanded. Similarly, also in the case where $\theta1 \neq \theta2$ and each of the values are multiple types, it is preferable since it is possible to obtain effects that the homogeneity of the light distribution outputted from the LED 2 and bipolarized by the prism 6 is enhanced, and the view angle for blocking the light incident on the lens 5 from the outside is expanded.

If only the shielding effect is considered, as for the region where the prism 6 is formed on the aperture 7, the wider is the region where the prism is formed, the higher is the effect. However, a part of the light emitted from the LED 2 is turned up in the front direction by the reflector 4 as described above, outputted from the region where the prism 6 is not formed, and this light is superimposed on the light bipolarized by the prism 6. Accordingly, the homogeneous light distribution characteristics are obtained as shown in FIG. 6(a) and FIG. 6(b). Therefore, it is desirable to configure the region for forming the prism 6, considering a required size and homogeneity of the imaging area. By way of example, as described above, the region is formed to be equivalent to the region where the phosphor resin layer 3 is placed.

Preferably, the reflector 4 may be made of metal or resin, in the shape of horn using a metallic layer made of silver or aluminum as a reflecting plane. In particular, it is preferable that a degree of brilliance is high on the reflecting plane, since it produces a large amount of normal reflection components. By way of example, if the degree of brilliance on the reflecting plane is equal to 0.6 or higher, it is particularly preferable, since the normal reflection components for the light with the wavelength 600 nm may become 10% or more.

Hereinafter, an explanation will be collectively made as to the operations of respective elements of the aforementioned lighting apparatus according to the present embodiment.

A part of blue light outputted from the LED 2 is absorbed in the phosphor of the phosphor resin layer 3, and emits fluorescence (yellow light, and the like). The white light which is a mixture of the blue light and the yellow light is outputted passing through the lens 5. On this occasion, the white light passing through the region where the prism 6 of the lens 5 is formed is bipolarized by the prism, with respect to the long side direction of the imaging area as shown in FIG. 5(a) to FIG. 5(c). On the other hand, the white light directly passing through the region of the lens 5 where the prism 6 is not formed, together with the white light reflected by the reflector 4 and then incident upon the region where the prism 6 is not formed, are outputted in the front direction without being bipolarized. Accordingly, the light being bipolarized by the prism 6 and the light directed in the front direction without passing through the prism 6 are superimposed one on another. Therefore, it is possible to obtain the light distribution characteristics being homogeneous across the large region as shown in FIG. 6(a) and FIG. 6(b), with respect to the long side direction of the imaging area.

As for the short-side direction of the imaging area, the prism 6 does not have the prism operation. Therefore, the light is outputted with the light distribution characteristics which have the strongest light intensity in the front direction, regardless of the prism formed region. The light beams at a large light distribution angle among the outputted light are reflected by the reflector 4, turned up in the front direction, and then outputted. Accordingly, it is possible to obtain homogeneous light distribution characteristics with respect to the short-side direction of the imaging area. Therefore, it is possible to irradiate the imaging area with the light homogeneous in any of the directions; the long-side direction and the short-side direction.

On the other hand, when light is not emitted from the LED, the lighting apparatus has a yellowish appearance on the phosphor of the phosphor resin layer 3. However, the outside light is retroreflected by the prism 6 within a predetermined view angle range from the front, and therefore, the outside light does not reach the phosphor. Accordingly, even though the light reaches the phosphor through the region on the lens 5 where the prism 6 is not formed, or from the long-side direction of the convex stripes of the prism 6, the light amount reaching the phosphor is considerably reduced as a whole. As thus described, the amount of the yellow light excited by the outside light and emitted by the phosphor is reduced, and it is possible to mitigate the problem where the yellowish color of the phosphor becomes visible.

As noted above, according to the lighting apparatus of the present embodiment, it is possible to provide an LED lighting apparatus which renders the yellowish color of the phosphor resin layer to be almost invisible and achieves a preferable appearance. In addition, the light emitted from the lighting apparatus is homogeneous across the large region with respect to the long-side direction of the imaging area. Therefore, this is suitable as an apparatus for illuminating the imaging area where the ratio of the long side to the short side is equal to 1 or more, i.e., it is suitable for use as a stroboscopic unit, for instance. The LED lighting apparatus of the present embodiment is small in size and has a good appearance, and therefore it is suitable for the stroboscopic unit mounted on a mobile phone or a compact camera.

In the present embodiment, the prism 6 having convex stripes is employed, which is in the shape of prism only uniaxially. Therefore, it is possible to easily manufacture the lens 5 provided with the prism 6 according to an injection molding using a die.

In the present embodiment, the aperture of the reflector 4 has a rectangular shape, and the longitudinal direction of the convex stripes of the prism 6 is made to agree with the short-side direction of the aperture. However, the shape of the aperture of the reflector 4 is not limited to the rectangular, and it may be a square shape, circular shape, oval shape, or slotted hole shape. In the case where the aperture shape having the longitudinal direction and the short-side direction, such as the oval shape and slotted hole shape, the longitudinal direction of the convex stripes is arranged to be in parallel with the short-side direction of the aperture, or with the short-side direction of the imaging screen (imaging area) of the camera. Accordingly, if used as the light source for a strobe, it is possible to provide a stroboscopic unit which is able to irradiate the imaging area with the light that is homogeneous both in the long side direction and in the short side direction.

**(Embodiment 2)**

In the embodiment 1 described above, as the prism 6, prisms (convex stripes) each having a triangular cross section are sequentially arranged (see FIG. 3(a)). However, in the embodiment 2, the shape and/or arrangement of the prism 6 are modified as shown in FIG. 3(b) or FIG. 3(c), so as to increase the light amount that is outputted in the front direction.

Specifically, as shown in FIG. 3(b) or FIG. 3(c), a curved section or a flat section is provided on a vertical angular part (peak) 6a of each convex stripe of the prism, and on an adjacent part (valley) 6b between the convex stripes. Since the other structure is the same as that of the FIG. 1(a) and FIG. 2 of the embodiment 1, a tedious explanation will not be made.

As thus described, by providing the curved section or the flat section, it is possible to make an effect similar to placing some distance between the prisms (convex stripes) and alleviating the continuity thereof. Therefore, though passing through the prism 6, light in the front direction is produced out of the light emitted from the LED 2. Accordingly, in the globular projection view in FIG. 6(a), it is possible to increase the light intensity of the light that is distributed in the front direction (0°).

In FIG. 3(b), the curved section is provided on both the vertical angular part 6a and the adjacent part 6b, but it may be provided on only one of them. For this case, it is desirable that the curved section is provided on the vertical angular part 6a. This is because the vertical angle part 6a contributes to collecting the incident light, and by processing the vertical angle part to be the curved shape, there is a large effect that the light distributed in the front direction is increased.

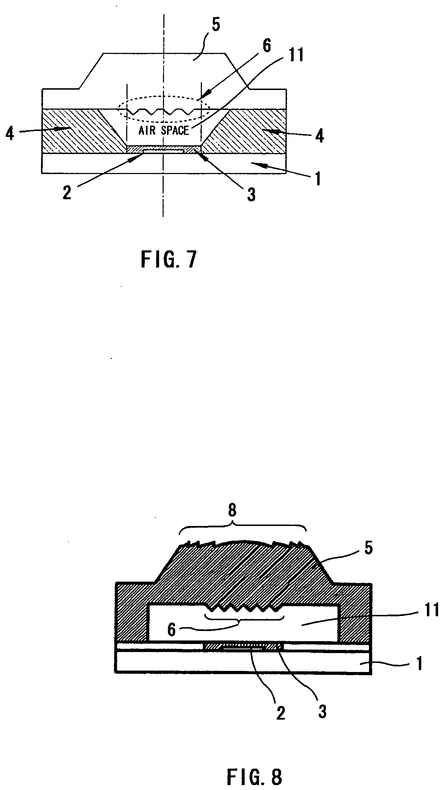

In the structure of FIG. 3(c), the flat section is provided on both the vertical angular part 6a and the adjacent part 6b, but it may be provided on only one of them. By way of example, as shown in FIG. 7, it is possible to take on a structure where the flat section is provided only on the adjacent part 6b.

(Embodiment 3)

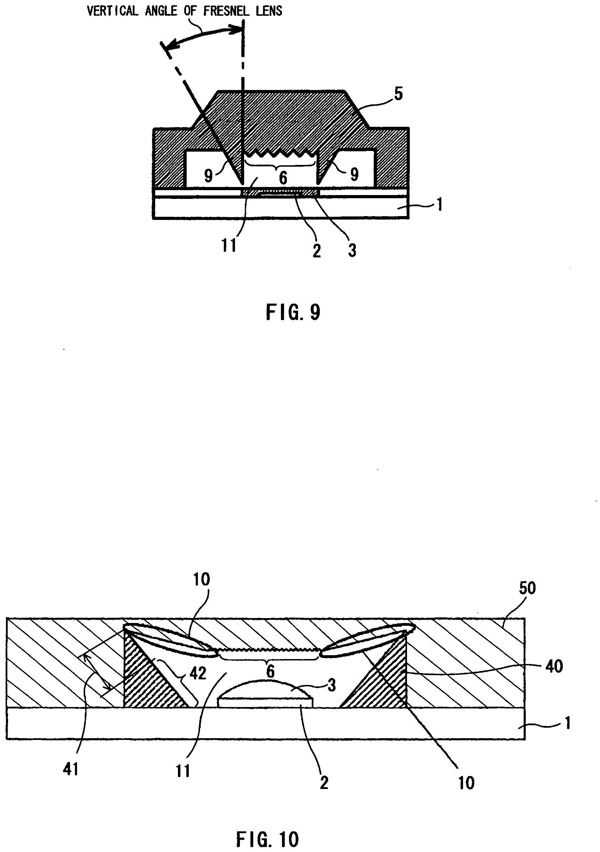

A lighting apparatus according to the embodiment 3 will be explained with reference to FIG. 8 and FIG. 9, in which a Fresnel lens is provided instead of the reflector 4 of the lighting apparatus of the embodiment 1.

The lighting apparatus as shown in FIG. 8 is not provided with the reflector 4, but a refraction type Fresnel lens 8 is formed on the outside surface of the lens 5. The other configuration is the same as that of the lighting apparatus of the embodiment 1. According to the refraction type Fresnel lens 8, a part of the light bipolarized by the prism 6 and the light not passing through the prism 6, out of the light emitted from the LED 2, can be turned up in the front direction (in the on-axis direction).

The lighting apparatus as shown in FIG. 9 is not provided with the reflector 4, and a reflection type Fresnel lens 9 is placed around the region where the prism 6 of the lens 5 is formed. By way of example, it is desirable that the vertical angle of the Fresnel lens is set to be around 20° to 40°. The other configuration is the same as the lighting apparatus of the embodiment 1.

The reflection type Fresnel lens 9 is able to turn up the light emitted from the LED 2 and does not incident on the prism 6, in the front direction (in the on-axis direction) . The reflection type Fresnel lens 9 is made up of two planes; a plane in parallel with the normal line direction of the lens 5 and an inclined plane.

The refraction type Fresnel lens is also made up of two planes; a plane in parallel with the normal line direction of the lens 5 and an inclined plane. As for the refraction type, only the inclined plane is utilized to refract the light incident on the inclined plane, thereby turning up the light in the front direction. On the other hand, the reflection type Fresnel lens refracts the light by the plane in parallel with the normal line, and entirely reflects the light by the inclined plane, thereby turning up the light in the front direction.

When the refraction type Fresnel lens is provided around the prism 6, an incident angle of the light from the LED 2 (the angle which the normal line direction of the inclined plane of the Fresnel lens forms with the incident light from the LED) is large. On the other hand, when the reflection type Fresnel lens is provided, the incident angle of the light from the LED 2 with respect to the plane being parallel with the normal line direction is small. Therefore, there is a merit that the reflection type Fresnel lens is smaller in light attenuation due to the refraction, than the refraction type Fresnel lens, when the light is turned up in the front direction. However, it is to be noted that as for the reflection type Fresnel lens, the light is not turned up in the front direction only by the refraction of the light on the plane being parallel with the normal line direction. Therefore, the refraction of the light is combined with the total reflection on the inclined plane, thereby suppressing the light attenuation, and raising the light in the front direction.

(Embodiment 4)

A lighting apparatus according to the embodiment 4 will be explained with reference to FIG. 10.

As shown in FIG. 10, the lighting apparatus of the embodiment 4 is different from the lighting apparatus of the embodiment 1 in the configuration of the reflector 40 and the lens 50.

In the present embodiment 4, the front edge of the reflector 40 is placed at a position higher than the prism 6 (at a position more distant from the LED 2). Therefore, there is formed a taper part 10 around the prism 6, connecting the prism 6 and the front edge of the reflector 40, on the surface of the lens 50 on the LED 2 side.

Since the reflector 40 is formed up to the position higher than the prism 6 as described above, a part of the light being bipolarized by the prism 6 passes through the lens 50, reaches the upper portion 41 of the reflector 40, and the light is reflected by the upper portion 41 of the reflector. Accordingly, a part of the light being bipolarized can be turned up in the front direction (in the on-axis direction).

On the other hand, a part of the light being bipolarized by the prism 6 is reflected by the taper part 10 and turned up in the front direction.

In the similar manner as the embodiment 1, the lower portion 42 of the reflector 40 turns up the light, which is outputted from the LED 2 and reaches the lower portion of the reflector 40 without being incident on the prism 6.

As thus described, according to the lighting apparatus as shown in FIG. 10, it is possible to obtain an effect that not only the light directly incident on the lower portion 42 of the reflector 40 from the LED 2, but also a part of the light bipolarized by the prism 6 are turned up in the front direction by the upper portion 41 of the reflector 40 and the taper part 10. Therefore, even when the reflector 40 is small in height, a large effect for turning up the light can be obtained, and since the height of the reflector 40 can be set to be small, a slim shape can be achieved. Consequently, even in the case where the lighting apparatus is low-profile, it is possible to irradiate the imaging area with homogeneous light.

In addition, since the prism 6 is placed, it is possible to provide the lighting apparatus in which the yellowish color of the phosphor resin layer 3 is almost invisible from the outside and an excellent appearance is achieved.

In the present embodiment 4, the taper part 10 is provided in the lens 50 and reflecting operation by the taper part 10 is utilized. However, if only the upper portion 41 and the lower portion 42 of the reflector 40 produce a sufficient effect for turning up the light, the taper part 10 is not necessarily provided. By way of example, it is alternatively possible to configure such that a step-like surface is placed instead of the taper part 10, combining a plane being parallel with the primary plane of the substrate 1 with a lens surface being vertical therewith, so as to connect the front edge of the reflector 40 and the prism 6.

FIG. 10 illustrates a structure in which the phosphor resin layer 3 is in the form of heaped up on the LED 2, but the present embodiment is not limited to this structure. It may be a flat film-like shape as shown in FIG. 2 of the embodiment 1. Since the other structure of FIG. 10 is the same as that of the embodiment 1, tedious explanations will not be made.

As explained with each of the embodiments described above, the lighting apparatus according to the present invention is allowed to irradiate the entire imaging area being a rectangular shape with homogeneous light. Since the prism 6 is placed, it is possible to provide the lighting apparatus in which the yellowish color of the phosphor resin layer 3 is almost invisible from the outside and an excellent appearance is achieved. In particular, the prism 6 is formed on the surface of the lens 5 on the side of the LED 2, thereby achieving an optical semiconductor lighting apparatus that does not impair designability of the lighting apparatus. In the optical semiconductor lighting apparatus, the shape, the forming region, and the density of the prism 6 of the lens 5 are adjusted, thereby controlling the shielding effect and homogeneous light distribution characteristics (in particular, extraction of the light in the on-axis direction). It is further possible to provide the optical semiconductor lighting apparatus which is able to combine the shielding effect and the homogeneous light distribution, by attaching the reflector 4 in addition to the prism 6.

## EXAMPLES

### (Example 1)

As the example 1, the lighting apparatus of the embodiment 2 was manufactured as shown in FIG. 7.

A desired substrate was prepared as the substrate 1, being selected from a glass epoxy substrate, a ceramic substrate, a metallic substrate, a frame inserted injection-molded product, and the like, and the LED 2 was mounted thereon. The LED having a peak wavelength of emission spectrum being from 380 to 500 nm was employed as the LED 2. As the mounting method, bonding may be employed using a conductive adhesive agent containing metallic filler, or a transparent adhesive agent of insulating type. Alternatively, solder joint, gold bump bonding, or the like, may be employed.

The reflector 4 was affixed to the substrate 1. As a method for bonding the substrate and the reflector, joining with an adhesive or the like may be taken as an example. For the reflector 4, a metallic luster-like product containing a large amount of normal reflection components was employed. Specifically, a product with a degree of brilliance of 0.6 or higher was used, which shows 10% or more of normal reflection components for the light having the wavelength 600 nm. In here, a product with a reflecting surface being subjected to silver plating was employed. The angle of the reflector was set to be from 20° to 40°, and the height of the reflector was set to be from 1.5 to 2.0 mm. When the height of the reflector is set to be 1.0 mm or higher, efficiency for extracting the light is enhanced.

Next, YAG with yellow luminescence was prepared as the phosphor. Then, this was dispersed in silicone resin.

By using the aperture of the reflector 4, the resin containing the phosphor was infused up to the height around 0.1 mm to 0.3 mm from the upper surface of the LED 2, and then it was cured to form the phosphor resin layer 3.

Next, the lens 5 was prepared. An a material of the lens 5, polycarbonate was used in order to enhance the shielding effect, the material having a high refractive index, high heat resistance, excellent in transparency, and being low in cost. On the surface of the lens 5 on the LED 2 side, the prism 6 having the same area as the phosphor resin layer 3 was formed. As shown in FIG. 7, the prism 6 included convex stripes each having a cross section in the shape of triangle, and it was formed in such a manner that a flat portion existed between the convex stripes (at a valley). An area occupied by the prism 6 (the area except the flat portions) within the region available for forming the prism was set to be around 50%. Only the vertexes of the convex stripes in the prism 6 were provided with curved surfaces of R = 5 $\mu$m to 50 $\mu$m. In the prism 6, the vertical angles $\theta$ existed in mixed manner, such as $\theta$ = 90° and $\theta$ = 100°. The convex stripe of the prism 6 was 30 $\mu$m in depth and 100 $\mu$m or less in width. The lens 5 was bonded to the reflector 4 by adhesive or the like.

In the lighting apparatus of the present embodiment, the yellow color of the phosphor resin layer 3 was invisible from the outward appearance. In addition, directional characteristics showed a light distribution which was optimum as strobe light for illuminating the imaging area with the ratio; X (longitudinal direction) = $\pm$30° and Y (short-side direction) = $\pm$20° as shown in FIG. 1(b). As for the optical property, the light extraction efficiency defined by the following formula (7) was 2 or more, and it was favorable.

$$\texttt{Light extraction efficiency = A/B ... (7)}$$

A: On-axial (front direction) intensity on the condition of Reflector + Lens + Phosphor + LED
B: On-axial (front direction) intensity on the condition of Phosphor + LED

The phosphor is not limited to YAG, and the effect of the present invention can be obtained by using the phosphor represented by MAlSiN$_3$:Eu (here, "M" is at least one element selected from Mg, Ca, Sr, Ba, and Zn), Orthosilicate based phosphor represented by (Ba,Sr,Ca)$_2$SiO$_4$:Eu, SiAlON phosphor, or the like.

## Claims

1. An LED lighting apparatus, comprising:

   a substrate (1),
   an LED (2) mounted on the substrate (1),
   a phosphor-containing layer (3) placed on the LED (2),
   a transparent body (5) placed at a position opposed to the LED (2), placing a certain space (11) therebetween,

   **characterized by**:

   a prism (6) made up of multiple linear convex stripes being arranged in parallel, the prism (6) being placed in a predetermined region on a surface of the transparent body (5), the surface being opposed to the LED (2),
   wherein the convex stripes have a structure to reflect outside light incident at least from the upside of the transparent body (5) along the normal direction of the substrate (1), in the upward direction of the transparent body (5),
   wherein the convex stripes have a first inclined plane and a second inclined plane which have an angle $\theta$ therebetween,
   wherein the angle $\theta$ of the convex stripes which achieve retroreflection at a predetermined viewing angle from -$\varphi$ to +$\varphi$, wherein $\varphi$ = 0 at the front view, satisfies the following formulas (1) to (4):

$$\texttt{90 - ($\theta$1 + $\varphi$) > sin}^{\texttt{-1}}\texttt{(1/n)} \qquad \texttt{... (1)}$$

$$\texttt{90 - ($\theta$2 + $\varphi$) > sin-1(1/n)} \qquad \texttt{... (2)}$$

$$\texttt{2 $\times$ $\theta$1 + $\theta$2 + $\varphi$ - 90 > sin-1(1/n) ... (3)}$$

$$\theta1 + 2 \times \theta2 + \varphi - 90 > sin-1(1/n) \quad ... \quad (4)$$

wherein, θ1 expresses an angle between the first inclined plane and a normal line of the substrate (1), θ2 expresses an angle between the second inclined plane and the normal line of the substrate (1), θ = θ1 + θ2, and n expresses a refraction index of the transparent body (5).

2. The LED lighting apparatus according to claim 1, **characterized in that**,

 the region on the transparent body (5) where the prism (6) is formed overlays all over the phosphor-containing layer (3).

3. The LED lighting apparatus according to either of claim 1 and claim 2, **characterized in that**,

 a reflector (4) having a predetermined aperture is placed around the LED (2), and the transparent body (5) is placed in such a manner as covering the aperture of the reflector (4).

4. The LED lighting apparatus according to claim 3, **characterized in that**,

 the aperture of the reflector (4) takes the shape having a longitudinal direction and a short-side direction, and the longitudinal direction of the convex stripes of the prism (6) is parallel to the short-side direction of the aperture.

5. The LED lighting apparatus according to either of claim 3 and claim 4, **characterized in that**,

 on the transparent body (5) inside the aperture, a second region where the prism (6) is not formed exists around the region where the prism (6) is formed.

6. The LED lighting apparatus according to claim 5, **characterized in that**,

 a front edge of the reflector (4) is positioned more distant from the LED (2) than the prism (6) of the transparent body (4).

7. The LED lighting apparatus according to claim 6, **characterized in that**,

 an inclined plane (10) is provided in a region between the front edge of the reflector (40) and the prism (6).

8. The LED lighting apparatus according to any one of claim 1 to claim 7, **characterized in that**,

 each of the multiple convex stripes has a triangular cross section, and the size of the vertical angle θ on the tip is identical or varies in multiple types.

9. The LED lighting apparatus according to any one of claim 1 to claim 8, **characterized in that**,

 each of the multiple convex stripes has a triangular cross section, and at least some of the convex stripes have the vertical angle θ on the tip being asymmetrical with respect to the normal line of the substrate (1).

10. The LED lighting apparatus according to any one of claim 1 to claim 9, **characterized in that**,

 a refractive type Fresnel lens (8, 9) is provided on the upper surface of the transparent body (5).

11. The LED lighting apparatus according to any one of claim 1 to claim 9, **characterized in that**,

 on the surface of the transparent body (5), being opposed to the LED (2), a reflective type Fresnel lens (9) is provided around the region where the prism (6) is formed.

12. A system provided with a stroboscopic function,

wherein the system comprises an LED lighting apparatus as a source of strobe light, and
wherein the LED lighting apparatus is defined in any one of claim 4 to claim 11.

**Patentansprüche**

1.  LED-Beleuchtungsvorrichtung, die Folgendes aufweist:

    ein Substrat (1),
    eine LED (2), die auf dem Substrat (1) angebracht ist,
    eine Phosphor bzw. Leuchtstoff enthaltende Schicht (3), die auf der LED (2) angeordnet ist,
    einen transparenten Körper (5), der bei einer Position gegenüberliegend der LED (2) angeordnet ist, wobei ein
    bestimmter Raum (11) dazwischen angeordnet ist,

    **gekennzeichnet durch**:

    ein Prisma (6), das aus mehreren linear-konvexen Streifen besteht, die parallel angeordnet sind, wobei das
    Prisma (6) in einem vorbestimmten Bereich auf einer Oberfläche des transparenten Körpers (5) angeordnet ist,
    wobei die Oberfläche der LED (2) gegenüber liegt,
    wobei die konvexen Streifen einen Aufbau aufweisen, um äußeres Licht zu reflektieren, das zumindest von der
    Oberseite des transparenten Körpers (5) entlang der normalen bzw. senkrechten Richtung des Substrats (1)
    einfällt, und zwar in der Aufwärtsrichtung des transparenten Körpers (5),
    wobei die konvexen Streifen eine erste geneigte Ebene und eine zweite geneigte Ebene aufweisen, die dazwischen einen Winkel θ aufweisen,
    wobei der Winkel θ der konvexen Streifen, die eine Retroreflexion bzw. Rückstrahlung bei einem bestimmten
    Betrachtungswinkel von -φ bis +φ erreichen, wobei φ = 0 bei der Frontansicht, die folgenden Formeln (1) bis
    (4) erfüllt:

    $$90 - (\theta 1 + \varphi) > \sin^{-1}(1/n) \qquad \ldots \qquad (1)$$

    $$90 - (\theta 2 + \varphi) > \sin^{-1}(1/n) \qquad \ldots \qquad (2)$$

    $$2 \times \theta 1 + \theta 2 + \varphi - 90 > \sin^{-1}(1/n) \qquad \ldots \qquad (3)$$

    $$\theta 1 + 2 \times \theta 2 + \varphi - 90 > \sin^{-1}(1/n) \qquad \ldots \qquad (4)$$

    wobei θ1 einen Winkel zwischen der ersten geneigten Ebene und einer senkrechten Linie des Substrats (1)
    bezeichnet, θ2 einen Winkel zwischen der zweiten geneigten Ebene und der senkrechten Linie des Substrats
    (1) bezeichnet, θ = θ1 + θ2, und n einen Brechungsindex des transparenten Körpers (5) bezeichnet.

2.  LED-Beleuchtungsvorrichtung gemäß Anspruch 1, **dadurch gekennzeichnet, dass** sich der Bereich auf dem transparenten Körper (5), wo das Prisma (6) gebildet ist, vollständig die Leuchtstoff enthaltende Schicht (3) überlagert.

3.  LED-Beleuchtungsvorrichtung gemäß entweder Anspruch 1 oder Anspruch 2, **dadurch gekennzeichnet, dass**
    ein Reflektor (4) mit einer vorbestimmten Öffnung um die LED (2) herum angeordnet ist, und der transparente Körper
    (5) in einer solchen Art und Weise angeordnet ist, dass er die Öffnung des Reflektors (4) abdeckt.

4.  LED-Beleuchtungsvorrichtung gemäß Anspruch 3, **dadurch gekennzeichnet, dass**,
    die Öffnung des Reflektors (4) die Form einnimmt, die eine Längsrichtung und eine Kurzseiten- bzw. Querrichtung
    aufweist, und die Längsrichtung der konvexen Streifen des Prismas (6) parallel zu der Querrichtung der Öffnung ist.

5.  LED-Beleuchtungsvorrichtung gemäß entweder Anspruch 3 oder Anspruch 4, **dadurch gekennzeichnet, dass**
    auf dem transparenten Körper (5) innerhalb der Öffnung ein zweiter Bereich, an dem das Prisma (6) nicht gebildet ist, um den Bereich herum existiert, an dem das Prisma (6) gebildet ist.

6. LED-Beleuchtungsvorrichtung gemäß Anspruch 5, **dadurch gekennzeichnet, dass**, eine Vorderkante des Reflektors (4) entfernter von der LED (2) als das Prisma (6) des transparenten Körpers (4) positioniert ist.

7. LED-Beleuchtungsvorrichtung gemäß Anspruch 6, **dadurch gekennzeichnet, dass**, eine geneigte Ebene (10) in einem Bereich zwischen der Vorderkante des Reflektors (40) und dem Prisma (6) vorgesehen ist.

8. LED-Beleuchtungsvorrichtung gemäß einem der Ansprüche 1 bis 7, **dadurch gekennzeichnet, dass** jeder der mehreren konvexen Streifen einen dreieckigen Querschnitt aufweist, und die Größe des vertikalen Winkels θ an der Spitze identisch ist oder bei mehreren Typen variiert.

9. LED-Beleuchtungsvorrichtung gemäß einem der Ansprüche 1 bis 8, **dadurch gekennzeichnet, dass** jeder der mehreren konvexen Streifen einen dreieckigen Querschnitt aufweist, und zumindest einige der konvexen Streifen den vertikalen Winkel θ aufweisen, der asymmetrisch in Bezug auf die senkrechte Linie des Substrats (1) ist.

10. LED-Beleuchtungsvorrichtung gemäß einem der Ansprüche 1 bis 9, **dadurch gekennzeichnet, dass** eine Fresnel-Linse (8, 9) der Brechungsbauart auf der oberen Oberfläche des transparenten Körpers (5) vorgesehen ist.

11. LED-Beleuchtungsvorrichtung gemäß einem der Ansprüche 1 bis 9, **dadurch gekennzeichnet, dass**, auf der Oberfläche des transparenten Körpers (5), der der LED (2) gegenüber liegt, eine Fresnel-Linse (9) der reflektierenden Bauart um den Bereich herum vorgesehen ist, an dem das Prisma (6) gebildet ist.

12. System, das mit einer Stroboskopfunktion vorgesehen ist, wobei das System eine LED-Beleuchtungsvorrichtung als eine Quelle des Stroboskoplichts aufweist, und wobei die LED-Beleuchtungsvorrichtung in einem der Ansprüche 4 bis Anspruch 11 definiert ist.

**Revendications**

1. Appareil d'éclairage à LED comprenant :

   un substrat (1),
   une LED (2) montée sur le substrat (1),
   une couche contenant du phosphore (3) placée sur la LED (2),
   un corps transparent (5) placé à une position opposée à la LED (2), ménageant un certain espace (11) entre eux,

   **caractérisé par** :

   un prisme (6) constitué de multiples bandes convexes linéaires, disposées en parallèle, le prisme (6) étant placé dans une région prédéterminée sur une surface du corps transparent (5), la surface étant opposée à la LED (2),
   dans lequel les bandes convexes ont une structure pour réfléchir la lumière extérieure incidente au moins de la face supérieure du corps transparent (5) le long de la direction normale du substrat (1), dans la direction montante du corps transparent (5),
   dans lequel les bandes convexes ont un premier plan incliné et un deuxième plan incliné qui font un angle θ entre eux,
   dans lequel l'angle θ des bandes convexes qui permet une retro réflexion à un premier angle de vue de - φ à + φ, avec φ = 0 en vue de face, respecte les formules (1) à (4) suivantes :

$$90 - (\theta 1 + \varphi) > \sin^{-1}(1/n) \qquad \ldots \quad (1)$$

$$90 - (\theta2 + \varphi) > \sin^{-1}(1/n) \qquad \ldots \quad (2)$$

$$2 \times \theta1 + \theta2 + \varphi - 90 > \sin^{-1}(1/n) \qquad \ldots \quad (3)$$

$$\theta1 + 2 \times \theta2 + \varphi - 90 > \sin^{-1}(1/n) \qquad \ldots \quad (4)$$

dans lesquelles $\theta1$ représente un angle entre le premier plan incliné et une ligne normale au substrat (1), $\theta2$ représente un angle entre le deuxième plan incliné et la ligne normale au substrat (1), $\theta = \theta1 + \theta2$, et n représente l'indice de réfraction du corps transparent (5).

2. Appareil d'éclairage à LED selon la revendication 1, **caractérisé en ce que**
la région du corps transparent (5) dans laquelle le prisme (6) est formé recouvre toute la couche contenant du phosphore (3).

3. Appareil d'éclairage à LED selon l'une des revendications 1 et 2, **caractérisé en ce que**
un réflecteur (4) ayant une ouverture prédéterminée est placé autour de la LED (2), et le corps transparent (5) est placé de manière à recouvrir l'ouverture du réflecteur (4).

4. Appareil d'éclairage à LED selon la revendication 3, **caractérisé en ce que**,
l'ouverture du réflecteur (4) prend la forme d'une direction longitudinale et d'une direction de petit côté, et la direction longitudinale des bandes convexes du prisme (6) est parallèle à la direction du petit côté de l'ouverture.

5. Appareil d'éclairage à LED selon l'une des revendications 3 et 4, **caractérisé en ce que**
il existe, sur le corps transparent (5) à l'intérieur de l'ouverture, autour de la région où le prisme (6) est formé, une deuxième région où le prisme (6) n'est pas formé.

6. Appareil d'éclairage à LED selon la revendication 5, **caractérisé en ce que**
un bord avant du réflecteur (4) est positionné plus loin de la LED (2) que le prisme (6) du corps transparent (5).

7. Appareil d'éclairage à LED selon la revendication 6, **caractérisé en ce que**
un plan incliné (10) est prévu dans une région située entre le bord avant du réflecteur (40) et le prisme (6).

8. Appareil d'éclairage à LED selon l'une quelconque des revendications 1 à 7, **caractérisé en ce que**
chacune des multiples bandes convexes a une section transversale triangulaire, et la valeur de l'angle vertical $\theta$ au sommet est identique ou varie selon les types.

9. Appareil d'éclairage à LED selon l'une quelconque des revendications 1 à 8, **caractérisé en ce que**
chacune des multiples bandes convexes a une section transversale triangulaire, et au moins certaines des bandes convexes ont un angle vertical $\theta$ au sommet qui est asymétrique par rapport à la ligne normale au substrat (1).

10. Appareil d'éclairage à LED selon l'une quelconque des revendications 1 à 9, **caractérisé en ce que**
une lentille de Fresnel du type à réfraction (8, 9) est prévue à la surface supérieure du corps transparent (5).

11. Appareil d'éclairage à LED selon l'une quelconque des revendications 1 à 9, **caractérisé en ce que**
une lentille de Fresnel du type à réflexion (9) est prévue, à la surface du corps transparent (5) à l'opposé de la LED (2), autour de la région où le prisme (6) est formé.

12. Système doté d'une fonction stroboscopique,
dans lequel le système comprend un appareil d'éclairage à LED en tant que source de lumière stroboscopique, et dans lequel l'appareil d'éclairage à LED est défini dans l'une quelconque des revendications 4 à 11.

## TOP VIEW

(a)

LONGITUDINAL DIRECTION

IMAGING SCREEN

SHORT-SIDE DIRECTION

(b)

**FIG. 1**

**FIG. 2**

PRISM VERTICAL ANGLE

(a)

PRISM DEPTH

VALLEY

PEAK

PRISM WIDTH

CURVES ARE PROVIDED ON VALLEY AND PEAK OF PRISM

(b)

6a    6b    6a    6b    6a

FLAT SURFACES ARE PROVIDED ON VALLEY AND PEAK OF PRISM

(c)

6a    6b    6a    6b    6a

FIG. 3

VIEW VIEW
ANGLE ANGLE
-φ +φ

IN ORDER TO ACHIEVE SHIELDING EFFECT,
TOTAL REFLECTION ON BOTH CASES I AND II
ABOVE IS REQUIRED.

II.
    $2*\theta 1+\theta 2+$VIEW ANGLE $\varphi-90<$ CRITICAL ANGLE $\alpha$
WHEN THE FORMULA ABOVE IS SATISFIED,
LIGHT BEAMS INITIALLY INCIDENT ON PRISM
ARE TOTALLY REFLECTED, AND
WHEN INCIDENT ON THE PRISM ON THE OPPOSITE SIDE,
THE LIGHT BEAMS ARE TOTALLY REFLECTED.

$\theta 1 \; \theta 2$

PRISM VERTICAL ANGLE
$\theta = \theta 1+\theta 2$

I.
    $90-(\theta 1+$VIEW ANGLE $\varphi)>$ CRITICAL ANGLE $\alpha$
WHEN THE FORMULA ABOVE IS SATISFIED,
LIGHT BEAMS INITIALLY INCIDENT ON PRISM
IS TOTALLY REFLECTED.

FIG. 4

0° (FRONT)    0°    0°

90°    90°

$\theta = 100°$    $\theta = 90°$    $\theta = 80°$

( a )    ( b )    ( c )

**FIG. 5**

GLOBULAR PROJECTION    SURFACE RADIATION

COMPARATIVE EXAMPLE
PRESENT EMBODIMENT

0° (FRONT)
COMPARATIVE EXAMPLE
PRESENT EMBODIMENT

90°

LONGITUDINAL DIRECTION
OF APERTURE

( b )

( a )

**FIG. 6**

FIG. 7

FIG. 8

VERTICAL ANGLE OF FRESNEL LENS

FIG. 9

FIG. 10

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009016779 A
- US 20040201987 A1
- JP 2006024615 A